# EUROPEAN PATENT SPECIFICATION

(11) **EP 2 387 083 B1**
(45) Date of publication and mention of the grant of the patent: **28.11.2012**
(21) Application number: 11003990.6
(22) Date of filing: 13.05.2011
(51) Int. Cl.: H01L 33/60, H01L 33/48, H01L 33/44

(54) **Substrate for mounting light-emitting element and light-emitting device**
Substrat zur Montage eines lichtemittierenden Elements und lichtemittierende Vorrichtung
Substrat pour assemblage d'élément électroluminescent et dispositif électroluminescent

(30) Priority: 14.05.2010 JP 2010112608
(43) Date of publication of application: 16.11.2011
(73) Proprietor: Asahi Glass Company, Limited, Chiyoda-ku Tokyo 100-8405 (JP)
(72) Inventor: Nakayama, Katsuyoshi, Tokyo 100-8405 (JP)
(74) Representative: Müller-Boré & Partner Patentanwälte

(56) References cited:
- EP-A2- 2 053 667
- WO-A1-2010/021367
- US-A1- 2009 315 057

## Description

The present invention relates to a substrate for mounting a light-emitting diode element and a light-emitting device employing it, particularly to a substrate for mounting a light-emitting diode element, which is excellent in flatness of a mounting surface to mount a light-emitting diode element is to be mounted, and of which deterioration in light extraction efficiency is suppressed, and a light-emitting device employing it.

In recent years, along with a tendency to high brightness and whitening of a light-emitting diode element (chip), a light-emitting device employing a light-emitting diode element has been used for illumination, backlights of various displays or large-sized liquid crystal TVs, etc. The substrate for mounting a light-emitting element, to mount a light-emitting diode element, is usually required to have a high reflectivity to efficiently reflect light emitted from the element.

However, there has been a problem that most of the lights entering the interior of a substrate from a light-emitting element are diffused and radiated in the interior of the substrate, and therefore it is impossible to adequately increase the proportion of lights reflected to the front of the substrate.

Accordingly, it has been heretofore attempted to provide a light reflection layer on the substrate surface for the purpose of reflecting light emitted from a light-emitting element to the front as far as possible. As such a light reflection layer, a silver reflection layer having a high reflectance is employed.

However, silver is likely to be corroded, and if it is left to stand in an exposed state, oxidation or sulfurization tends to occur on the surface of the silver reflection layer, whereby optical reflectance deteriorates and it is thereby impossible to obtain sufficient light extraction efficiency.

Accordingly, it has been proposed to cover the surface of the light reflection layer with a resin such as a silicone resin, an acrylic resin, an epoxy resin or a urethane resin so as to prevent deterioration of the optical reflectance (e.g. Patent Document 1 : JP-A-2007-67116).

However, even when the silver reflection layer is covered with such a resin, the sealing property is inadequate, and therefore corrosive gas or liquid is likely to pass through the resin itself, or gas or liquid is likely to infiltrate from the interface between the resin and a substrate, whereby it is impossible to sufficiently prevent the deterioration of the optical reflectance due to oxidation or sulfurization of the silver reflection layer.

Accordingly, in recent years, it has been studied to protect the light reflection layer by providing a glass-made protective layer on the upper surface of the light reflection layer.

With the glass-made protective layer, the sealing property is excellent as compared with a resin-made protective layer, further the light transmittance is high, and the quantity of light arriving at the light reflection layer increases, whereby it is possible to obtain a high reflectance. Further, glass is excellent in the thermal conductivity, and therefore in a case where a glass layer is provided as a protective layer for the light reflection layer, it is possible to obtain a heat dissipating property higher than a case where a resin layer is provided.

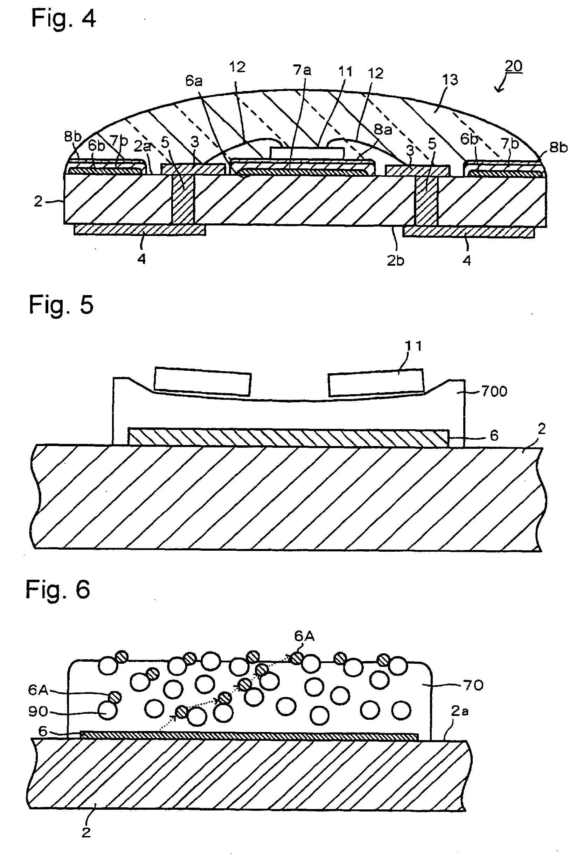

However, in such a case where a glass layer is provided as a protective layer for the light reflection layer, deformation due to e.g. swell tends to occur during firing since a sintered product of a glass powder usually has a high fluidity in a non-fired state. Accordingly, as shown in figure 5 for example, not a little irregularities are formed on the surface of a fired product, and the flatness of the surface of a glass layer 700 deteriorates. In a case where a light-emitting element 11 is mounted on such a glass layer 700, the contact area between the element 11 and the glass layer 700 is small, and therefore the heat resistance increases. Especially, in the case of a light emitting diode element in recent years, heat generation increases along with a tendency to high brightness, and therefore it is required to suppress the increase of the heat resistance.

Further, if irregularities are formed on the mounting portion, the light-emitting element is likely to be fixed with an inclination and damaged by subsequent wire bonding, and further an optical axis is also likely to be displaced.

WO 2010/021367 A1 discloses a light-emitting device comprising a substrate bearing a conductor layer formed thereon and a light-emitting element placed on the conductor layer which is covered with an overcoat layer comprising a borosilicate glass. This light-emitting device exhibits high light reflectivity and is also improved in light extraction.

EP 2 053 667 A2 discloses a package structure for photoelectronic devices which comprises a silicon substrate, a first insulating layer, a reflective layer, a second insulating layer, a first and a second conductive layer and a die.

US 2009/0315057 A1 discloses a light-emitting apparatus having at least one semiconductor device which emits light toward a higher position than a substrate and a plurality of external connection terminals and which comprises a light-reflecting layer and a covering layer.

### PRIOR ART DOCUMENT

Patent Document 1: JP-A-2007-67116

In order to solve these problems, in recent years, it has been studied to provide a glass layer (overcoat layer) having a ceramic filler incorporated, as a protective layer for a light reflection layer. When the protective layer is made of a mixture of a glass powder and a ceramic filler, the fluidity in a non-fired state is lowered, and deformation due to e.g. swell during firing is suppressed. Accordingly, the proportion of protrusions on the surface of a fired product is reduced, and the flatness becomes high.

Further, in a case where the ceramic filler is incorporated in the glass layer, the reflection direction of light entering the glass layer from a light emitting element can be dispersed, whereby fluctuation in light distribution characteristics can also be reduced.

However, in a case of a glass layer containing, as the ceramic filler, e.g. an alumina ceramic filler containing Al₂O₃ as the main component, as shown in Fig. 6, such a phenomenon (migration phenomenon) is likely to occur that silver ions 6 A in a reaction layer 6 formed from a metal powder containing silver as the main component, sequentially diffuse to the surface of the respective particles of alumina ceramic filler 90.

In such a case, silver ions 6A diffuse towards the surface layer side in the glass layer 70 while becoming higher concentration state, and therefore silver ions 6A cohere on the surface of the glass layer 70 to be silver particles and part of the silver particles are sometimes exposed from the glass layer 70.

In a case where such a surface of the substrate for mounting a light-emitting element is sealed with a sealing material such as a silicone resin, the silver particles exposed on the surface are likely to be in contact with e.g. a platinum catalyst contained in the sealing material (molding material) and formed into ions again, and they are likely to cohere to be formed into colloidal particles. In such a situation, if it is left to stand in a constant temperature and constant humidity environment for a long time, colloidal particles cohere, and thereby cause a phenomenon of so-called silver coloring in which the sealing material (mold material) or the glass layer is yellowed or browned.

If the sealing material is colored, light emitted from a light emitting element is likely to be absorbed in the colored material, whereby light intensity as a light emitting device is likely to deteriorate.

The present invention has been made to solve such problems, and it is an object of the present invention to provide a substrate for mounting a light-emitting diode element, being less susceptible to the loss of light supplied from a light-emitting diode element, having high utilization efficiency of light, being excellent in flatness of a mounting surface on which a light-emitting diode element is to be mounted, having a low heat resistance, and being capable of suppressing inclination of the light-emitting diode element, when used for a light-emitting device. Further, it is an object of the present invention to provide a light emitting device using the above substrate for mounting a light-emitting diode element.

The present inventor has conducted extensive studies and as a result, has found it possible to solve the above problems by the substrate for mounting a light-emitting diode element and the light-emitting device of the present invention, and accomplished the present invention.

That is, the substrate for mounting a light-emitting diode element (also designated as "light-emitting element") of the present invention comprises a substrate main body, a reflection layer composed mainly of silver (Ag) or a silver alloy, formed on a part of the substrate main body, a first protective layer composed mainly of a sintered product of a glass powder, formed so as to cover the entire surface of the reflection layer, characterised in that the first protective layer (7) contains less than 0·1% alumina filler (90), and in that said substrate further comprises a second protective layer a part of which constitutes a mounting portion on which a light-emitting element is to be mounted, formed on the first protective layer, wherein the second protective layer is made of a sintered product of a glass powder containing a ceramic filler.

The above first protective layer contains substantially no alumina filler, but it may contain a ceramic filler other than the alumina filler. In such a case, the content of the ceramic filler other than the alumina filler, contained in the above first protective layer, is preferably at most 30 mass%, particularly preferably at most 0.5 mass%. Further, the concentration of silver (Ag) or a silver alloy contained in the above first protective layer is at most 0.3%.

The content of the ceramic filler contained in the second protective layer is preferably at least 10 mass% and at most 30 mass%. Further, the ceramic filler contained in the second protective layer is preferably one or a mixture of at least two selected from an alumina powder (the content of Al₂O₃ is at least 95 mass%), a zirconia powder, a titania powder and a silica powder.

The thickness of the first protective layer is preferably at least 10 µm and at most 30 µm. Further, the thickness of the second protective layer is preferably at least 10 µm and at most 30 µm.

The reflection layer is preferably composed of a layer containing a metal selected from silver and an alloy of silver with an element of a platinum group, such as a silver/palladium alloy or a silver/platinum alloy.

The light-emitting device of the present invention comprises the substrate for mounting a light-emitting element of the present invention, and a light-emitting element mounted on the mounting portion of the substrate for mounting a light-emitting element. Further, the light-emitting device of the present invention is preferably one wherein a part or all of the surface of the substrate main body and of the second protective layer are sealed with a silicone resin containing a platinum catalyst.

According to the present invention, it is possible to obtain a substrate for mounting a light-emitting element in which the amount of silver particles exposed on the surface of a protective layer is reduced, by laminating the first protective layer containing substantially no alumina filler and the second protective layer containing a ceramic filler on a silver reflection layer. Further, it is possible to obtain a substrate for mounting a light-emitting element being capable of improving the flatness of the mounting portion of the light-emitting element, having a low heat resistance, and being capable of suppressing inclination of the light-emitting element.

Further, according to the present invention, by mounting a light-emitting element on such a substrate for mounting a light-emitting element, it is possible to obtain a light-emitting device being less susceptible to the loss of light supplied from the light-emitting element, being capable of obtaining sufficient light-emitting brightness, and further being capable of suppressing a damage or displacement of an optical axis of the light-emitting element.
Fig. 1 is a cross-sectional view illustrating an example of the substrate for mounting a light-emitting element of the present invention.
Fig. 2 is an enlarged view illustrating a periphery of a first protective layer 7a and a second protective layer 8a.
Fig. 3 is an enlarged cross-sectional view illustrating a state where a light-emitting element is mounted on the substrate for mounting a light-emitting element of the present invention.
Fig. 4 is a cross-sectional view illustrating an example of the light-emitting device of the present invention.
Fig. 5 is a cross-sectional view illustrating a state where a light-emitting element is mounted on a substrate for mounting a light-emitting element according to another embodiment.
Fig. 6 is a cross-sectional view schematically illustrating a state in a firing step of a substrate for mounting a light-emitting element according to another embodiment.

Now, the present invention will be described in detail.

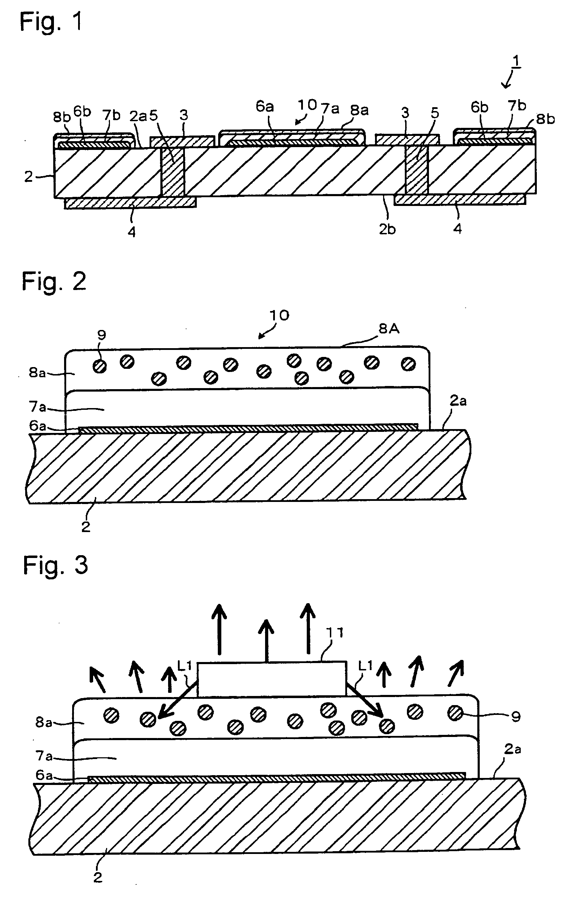

Fig. 1 is a cross-sectional view illustrating an example of the substrate for mounting a light-emitting element of the present invention.

A substrate 1 for mounting a light-emitting element has a substantially flat plate-form substrate main body 2. One of the main surfaces of the substrate main body 2 is a mounting surface 2a on which a light-emitting diode element is to be mounted. On the mounting surface 2a, connection terminals 3 to be electrically connected to the light-emitting element are provided. Further, the other main surface of the substrate main body 2 is a non-mounting surface 2b on which no light-emitting element is to be mounted, and on the non-mounting surface 2b, external electrode terminals 4 to be electrically connected to an external circuit, are provided. Further, in the interior of the substrate main body 2, via conductors 5 for electrically connecting these connection terminals 3 and the external electrode terminals 4, are provided.

On a substantially center portion of the mounting surface 2a of the substrate 2, a reflection layer 6a for reflecting light emitted from a light-emitting element, is provided, and on the reflection layer 6a, a first protective layer 7a is provided so as to cover the entire surface of the reflection layer 6a. Further, on the upper surface of the first protective layer 7a, a second protective layer 8a is provided, a part of which constitutes a mounting portion 10 on which a light-emitting element is to be mounted.

Further, also on both edges in the longitudinal direction of the mounting surface 2a in Fig. 1, reflection layers 6b for reflecting light emitted from the light-emitting element are respectively provided. On each reflection layer 6b, a first protective layer 7b is provided so as to cover the entire surface of the reflection layer 6b, and on the upper surface of the first protective layer 7b, a second protective layer 8b is provided (hereinafter, the reflection layer 6a and the reflection layer 6b will be referred to as a reflection layer 6, the first protective layer 7a and the first protective layer 7b will be referred to as a first protective layer 7, and the second protective layer 8a and the second protective layer 8b will be referred to as a second protective layer 8).

Fig. 2 is an enlarged view illustrating a periphery of the first protective layer 7a and the second protective layer 8a.

The first protective layer 7 composed mainly of a sintered product of a glass powder, and is provided so as to completely cover the reflection layer 6. Further, the second protective layer 8 is provided on the upper surface of the first protective layer 7, and is composed of a sintered product of a glass powder containing a ceramic filler 9.

By the first protective layer 7 and the second protective layer 8, infiltration of gas or liquid to the reflection layer 6 can be suppressed, whereby it is possible to prevent oxidation or sulfurization of the reflection layer 6.

The reflection layer 6 can be formed in such a method that a vehicle such as ethyl cellulose and, as the case requires, a solvent etc. are added to a metal powder of e.g. silver, a silver/palladium alloy or a silver/platinum alloy, and the resulting paste is printed on the substrate main body 2 by means of e.g. screen printing. The metal powder to be used for the reflection layer 6 is preferably one having a high reflectance, particularly preferably silver. In the case of the reflection layer 6 for which the above silver alloy is used, it means a reflection layer 6 containing at least 90 mass% of silver. In the case of the silver/palladium alloy, palladium may be contained in an amount of at most 10 mass%. In the case of the silver/platinum alloy, platinum may be contained in an amount of at most 3 mass%.

The first protective layer 7 is composed mainly of a sintered product of a glass powder, and the protective layer 7 is composed as a layer containing substantially no alumina filler.

Further, in this specification, "alumina filler" is a ceramic filler containing at least 50 mass% of Al₂O₃ as a chemical component, and the expression "contains substantially no alumina filler" means a case where the content of the alumina filler in the first protective layer 7 is less than 0.1 %.

With such a first protective layer 7, it is possible to produce a substrate for mounting a light-emitting element in which the amount of silver particles exposed on the surface of the second protective layer 8 is extremely reduced.

That is, it is considered that, as shown in e.g. Fig. 6, in a case where a protective layer 70 containing an alumina filler 90 is provided on the reflection layer 6 so as to be in contact therewith, silver (Ag) atoms in the reflection layer 6 liberate as silver (Ag) ions from the reflection layer 6 during heating and firing, diffuse in the protective layer 70 by a migration phenomenon, and deposit in and on the layer.

Specifically, it is considered that the migration phenomenon occurs in such a method that silver ions 6A liberated from the reflection layer 6 diffuse to the protective layer 70 and arrive at the interface between the alumina filler 90 and the glass powder, and alkali substitution between the silver (Ag) ion 6A and a particle of the alumina filler 90, whereupon the silver (Ag) ions 6A sequentially diffuse to the surface of other particles of the alumina filler 90 and thereby move to the surface layer side in the protective layer 7.

Accordingly, a first protective layer 7 containing substantially no such an alumina filler 90 can reduce the amount of silver (Ag) ions which move in the first protective layer 7, whereby it is possible to suppress increase of the concentration of the silver ions of the first protective layer 7, and it is thereby possible to obtain a substrate for mounting a light-emitting element in which the silver (Ag) ions arriving at the second protective layer 8 are reduced.

Further, there is a possibility that the above-mentioned migration phenomenon occurs even when a ceramic filler other than the alumina filler is contained in the protective layer being in contact with the silver reflection layer 6, but the possibility is relatively quite low as compared with the case of the alumina filler, and therefore it is important that the first protective layer 7 contains substantially no alumina filler.

The concentration of silver (Ag) or a silver alloy contained in the first protective layer 7 is preferably at most 0.3%, more preferably at most 0.15%, particularly preferably at most 0.1 %.

The above-mentioned concentration of silver (Ag) or a silver alloy of the first protective layer 7 can be adjusted by suitably adjusting the content of the alumina filler of the first protective layer 7, or the type or the content of the ceramic filler other than the alumina filler contained in the first protective layer 7.

By providing the above first protective layer 7 between the reflection layer 6 and the second protective layer 8, it is possible to substantially block the migration phenomenon of the silver ions 6A from the reflection layer 6 to the side of the second protective layer 8, in the region of the first protective layer 7. Accordingly, the silver ions 6A hardly arrive at the second protective layer 8, and therefore it is possible to obtain a second protective layer 8 in which the amount of silver particles exposed on the surface 8A of the second protective layer 8 is extremely reduced.

The above-mentioned migration phenomenon tends to occur especially between silver ions and Al₂O₃, and therefore it is particularly preferred that the first protective layer 7 contains substantially no alumina powder with a high Al₂O₃ content (Al₂O₃ content of at least 95 mass%), among the above-mentioned alumina fillers.

However, a ceramic filler to be used heretofore may be contained so long as it is one other than the alumina filler. Specifically, for example, a zirconia powder, a titania powder, a silica powder or a mixture thereof may be contained in the first protective layer 7. The 50% particle size (D₅₀) of the ceramic filler is preferably at least 0.5 µm and at most 4 µm for example. Here, in this specification, the 50% particle size (D₅₀) is one measured by means of a laser diffraction/scattering type particle size distribution measuring apparatus.

In a case where the first protective layer 7 contains a ceramic filler other than the alumina filler, the content of the ceramic filler other than the alumina filler to the first protective layer 7 is preferably at most 30 mass%.

If the content of the ceramic filler other than the alumina filler to the first protective layer 7 exceeds 30 mass%, firing of the protective layer 7 tends to be insufficient, and its acid resistance or strength tends to deteriorate, whereby the protective layer 7 may not sufficiently function as a protective layer for the reflection layer 6.

The content of the ceramic filler other than the alumina filler to the first protective layer 7 is preferably at most 10 mass%, particularly preferably at most 0.5 mass%,.

The glass powder to be used for the first protective layer 7 is preferably one having a softening point (Ts) of at most 900°C.

When the softening point (Ts) of the glass powder exceeds 900°C, it is required that the firing temperature exceeds 900°C in order to obtain a dense sintered product by firing such a glass powder, but in such a case, the reflection layer 6 is likely to deform at the time of firing the glass powder simultaneously with one composed mainly of silver to be suitably used as the reflection layer 6.

By using the one having a softening point (Ts) of at most 900°C as the glass powder for the first protective layer, the glass paste for the first protective layer and the reflection layer 6 can be fired simultaneously without deformation of the reflection layer 6.

On the other hand, usually, if a glass powder having a low softening point is fired simultaneously with silver, silver ions are diffused into the glass powder in a molten state, and further such silver ions are formed into colloidal particles, thus leading to a phenomenon called silver coloring in which a sintered product of the glass powder is colored yellow or red. Such a phenomenon is likely to occur as the softening point of the glass powder is lower.

If a sintered product of the glass powder for the first protective layer is colored, the reflectance of the first protective layer 7 will be deteriorated. Accordingly, it is preferred to use a glass powder which is not colored even when fired simultaneously with silver.

As such a glass powder, it is preferred to use a borosilicate glass which comprises from 62 to 84 mol% of SiO₂, from 10 to 25 mol% of B₂O₃, from 0 to 5 mol% of Al₂O₃, from 0 to 10 mol% of MgO, and from 0 to 5 mol% in total of at least one selected from Na₂O and K₂O provided that the total content of SiO₂and Al₂O₃ is from 62 to 84 mol%, and if at least one of CaO, SrO and BaO is contained, the total content is at most 5%.

By using a glass powder having the above composition as the glass powder for the first protective layer 7, it is possible to obtain a dense sintered product without deformation of the reflection layer 6 even when fired simultaneously with the reflection layer 6. Further, even when it is fired simultaneously with the reflection layer 6, a sintered product is not colored, and the reflectance of the first protective layer 7 is not also deteriorated.

SiO₂ is a glass network former, and it is a component to increase chemical durability, particularly acid resistance and thus is essential. If the content of SiO₂ is less than 62 mol%, the acid resistance is likely to be inadequate. On the other hand, if the content of SiO₂ exceeds 84 mol%, the glass softening point (Ts) or the glass transition point (Tg) tend to be too high.

B₂O₃ is a glass network former. If the content of B₂O₃ is less than 10 mol%, the softening point (Ts) is likely to be too high, or the glass tends to be unstable. On the other hand, if the content of B₂O₃ exceeds 25 mol%, it becomes difficult to obtain a stable glass, or the chemical durability may deteriorate. The content of B₂O₃ is preferably at least 12 mol%.

Al₂O₃ may be added within a range of at most 5 mol% in order to increase the glass stability and chemical durability. If the content of Al₂O₃ exceeds 5 mol%, transparency of glass is likely to deteriorate. Further, if the content of Al₂O₃ exceeds 5 mol%, silver coloring is likely to occur.

Na₂O and K₂O may be added within a range not to exceed 5 mol% in total, in order to lower the softening point (Ts) or the glass transition point (Tg). If the total content of Na₂O and K₂O exceeds 5 mol%, chemical durability, particularly acid resistance is likely to deteriorate, and the electrical insulation property is also likely to deteriorate. Further, if the total content of Na₂O and K₂O exceeds 5 mol%, silver coloring is likely to occur.

At least one of Na₂O and K₂O is preferably contained, and the total content of Na₂O and K₂O is preferably at least 0.9 mol%.

Further, the total content of SiO₂ and Al₂O₃ is from 62 mol% to 84 mol% in total.

If the total content of SiO₂ and Al₂O₃ is less than 62 mol%, chemical durability is likely to be inadequate. On the other hand, if the total content of SiO₂ and Al₂O₃ exceeds 84 mol%, the softening point (Ts) or the glass transition point (Tg) is likely to be too high.

MgO may be added within a range not to exceed 10 mol% in order to lower the softening point (Ts) or the glass transition point (Tg) and to increase the glass stability.

If the content of MgO exceeds 10 mol%, silver coloring is likely to occur.

The content of MgO is preferably at most 8 mol%.

CaO, SrO or BaO may be added within a range not to exceed 5 mol% in total, in order to lower the softening point (Ts) or the glass transition point (Tg) and to increase the glass stability. If the total content of CaO, SrO and BaO exceeds 5 mol%, the acid resistance is likely to deteriorate. Further, If the total content of CaO, SrO and BaO exceeds 5 mol%, the silver coloring is likely to occur.

Further, the glass powder to be used for the first protective layer 7 is not necessarily limited to the one composed solely of the above components, and other components may be contained within a range not to impair the object of the present invention. Further, in this embodiment, no lead oxide is contained. In a case where other components are contained, the total content thereof is preferably at most 10 mol%.

Further, the glass powder to be used for the first protective layer 7 is not limited to one having the above content proportion, and it is also possible to use a glass powder having a content proportion different therefrom.

The acid resistance of the first protective layer 7 is preferably at most 100 µg/cm², more preferably at most 30 µpg/cm², furthermore preferably at most 5 µg/cm², particularly preferably at most 1 µg/cm².

If the acid resistance of the first protective layer 7 exceeds 100 µg/cm², glass components of the first protective layer 7 are likely to elute into the plating treatment solution of the reflection layer 6, wherein a continuous operation is likely to be obstructed at the time of producing a substrate, or the first protective layer 7 is likely to be turbid, whereby the reflectance may be deteriorated.

The acid resistance of the first protective layer 7 can be evaluated by measuring a decrease in mass upon expiration of 1 hour after immersing it in 700 cm³ of an oxalate buffer solution having a pH of 1.68 at a temperature of 85°C.

As another glass powder to be used for the first protective layer 7, for example, it is preferred to use one (hereinafter referred to as "glass A") which comprises from 78 to 83 mol% of SiO₂, from 16 to 18 mol% of B₂O₃, from 0.9 to 4 mol% in total of at least one of Na₂O and K₂O, from 0 to 0.5 mol% of Al₂O₃, and from 0 to 0.6 mol% of CaO, in order to increase the reflectance of the first protective layer 7.

Now, the composition of "glass A" will be described.

SiO₂ is a glass network former. If the content of SiO₂ is less than 78 mol%, the chemical durability is likely to deteriorate. On the other hand, if the content of SiO₂ exceeds 83 mol%, the softening point (Ts) or the glass transition point (Tg) tends to be too high.

The content of SiO₂ is preferably at least 80 mol%. Further, the content of SiO₂ is preferably at most 82 mol%, more preferably at most 81 mol%.

B₂O₃ is a glass network former.

If the content of B₂O₃ is less than 16 mol%, the softening point (Ts) or the glass transition point (Tg) is likely to be too high. On the other hand, if the content of B₂O₃ exceeds 18 mol%, it tends to be difficult to obtain stable glass, and further the chemical durability is also likely to deteriorate.

The content of B₂O₃ is preferably at most 17 mol%.

Al₂O₃ may be added within a range of at most 0.5 mol% in order to increase the stability and chemical durability of glass. If the content of Al₂O₃ exceeds 0.5 mol%, the softening point (Ts) or the glass transition point (Tg) tends to be too high. If the content of Al₂O₃ exceeds 0.5 mol%, silver coloring is likely to occur.

Na₂O and K₂O are ones added in order to lower the softening point (Ts) or the glass transition point (Tg), and it is necessary to incorporate at least one of Na₂O and K₂O.

If the total content of Na₂O and K₂O is less than 0.9 mol%, the softening point (Ts) or the glass transition point (Tg) is likely to be too high. On the other hand, if the total content of Na₂O and K₂O exceeds 4 mol%, the chemical durability, particularly the acid resistance, is likely to deteriorate, and the electrical insulation property is also likely to deteriorate. Further, if the total content of Na₂O and K₂O exceeds 4 mol%, silver coloring is likely to occur.

The total content of Na₂O and K₂O is preferably at least 1.0 mol%, more preferably at least 1.5 mol%. Further, the total content of Na₂O and K₂O is preferably at most 3 mol%, more preferably at most 2 mol%.

CaO may be added within a range not to exceed 0.6 mol% in order to lower the softening point (Ts) or the glass transition point (Tg) and to increase the glass stability.

If the content of CaO exceeds 0.6 mol%, the softening point (Ts) or the glass transition point (Tg) is likely to be too low, or the crystallization tends to be accelerated, whereby a transparent glass tends to be hardly obtainable. Further, if the content of CaO exceeds 0.6 mol%, silver coloring tends to occur.

Further, as another glass powder, for example, it is preferred to use a glass powder (hereinafter referred to as glass B) which comprises from 72 to 78 mol% of SiO₂, from 13 to 18 mol% of B₂O₃, from 0.9 to 4 mol% in total of at least one of Na₂O and K₂O, and from 2 to 10 mol% of MgO, since the reflectance of the first protective layer 7 is increased.

Now, the composition of "glass B" will be described.

SiO₂ is a glass network former. If the content of SiO₂ is less than 72 mol%, the chemical durability is likely to deteriorate. On the other hand, if the content of SiO₂ exceeds 78 mol%, the glass softening point (Ts) or the glass transition point (Tg) is likely to be too high.

The content of SiO₂ is preferably at least 73 mol%. Further, the content of SiO₂ is preferably at most 76 mol%.

B₂O₃ is a glass network former.

If the content of B₂O₃ is less than 13 mol%, the glass softening point (Ts) or the glass transition point (Tg) is likely to be too high. On the other hand, if the content of B₂O₃ exceeds 18 mol%, it tends to be difficult to obtain stable glass, and the chemical durability is also likely to deteriorate. The content of B₂O₃ is preferably at most 17 mol%.

MgO is added in order to lower the softening point (Ts) or the glass transition point (Tg), and to increase the stability of glass.

If the content of MgO is less than 2 mol%, the softening point (Ts) or the glass transition point (Tg) is likely to be too high, and further the glass is likely to be unstable. On the other hand, if the content of MgO exceeds 10 mol%, silver coloring is likely to occur.

The content of MgO is preferably at least 4 mol%. Further, the content of MgO is preferably at most 8 mol%, more preferably at most 6 mol%.

Na₂O and K₂O are ones to be added in order to lower the softening point (Ts) or the glass transition point (Tg), and it is necessary to incorporate at least one of Na₂O and K₂O.

If the total content of Na₂O and K₂O is less than 0.9 mol%, the softening point (Ts) or the glass transition point (Tg) is likely to be too high. On the other hand, if the total content of Na₂O and K₂O exceeds 4 mol%, the chemical durability, particularly the acid resistance, is likely to deteriorate, and the electrical insulation property is also likely to deteriorate. Further, if the total content of Na₂O and K₂O exceeds 4 mol%, silver coloring is likely to occur.

The total content of Na₂O and K₂O is preferably at least 1.0 mol%, more preferably at least 1.5 mol%. Further, the total content of Na₂0 and K₂O is preferably at most 3 mol%.

Further, the glass powder to be used for the first protective layer 7 is not limited to one consisting solely of the above-mentioned components of "glass A" or "glass B", but may contain other components within a range not to impair the object of the present invention. Here, in this embodiment, no lead oxide is contained. In a case where other components are contained, the total content thereof is preferably at most 10 mol%.

The glass powder to be used for the first protective layer 7 can be obtained by producing a glass having the above-described glass composition by a melting method and grinding it by a dry grinding method or a wet grinding method. In the case of a wet grinding method, it is preferred to employ water as a solvent. The grinding can be carried out by using a grinding machine such as a roll mill, a ball mill or a jet mill.

The 50% particle size (D₅₀) of the glass powder to be used for the first protective layer 7 is preferably from 0.5 µm to 4 µm. If the 50% particle size of the glass powder is less than 0.5 µm, the glass power is likely to cohere, whereby the handling tends to be difficult, and it may take a long time for pulverization. On the other hand, if the 50% particle size of the glass powder exceeds 4 µm, the glass softening temperature is likely to rise, or the sintering is likely to be inadequate. The particle size can be adjusted, for example, by classification which is carried out after the grinding, as the case requires.

Further, in this specification, the 50% particle size (D₅₀) is one measured by means of a laser diffraction scattering type particle size distribution measuring apparatus.

Further, the maximum particle size of the glass powder is preferably at most 20 µm. If the maximum particle size exceeds 20 µm, the sintering property of the glass powder deteriorates, and unmelted components remain in a sintered product, whereby the reflectivity of the first protective layer 7 is likely to deteriorate.

The maximum particle size of the glass powder is more preferably at most 10 µm.

Since the above first protective layer 7 has a high fluidity during firing, deformation readily occur due to e.g. swell after the firing. Accordingly, if the first protective layer 7 is provided as a surface layer, the surface irregularities readily form on the surface of the sintered product, whereby the flatness deteriorates.

The second protective layer 8 is made of a sintered product of a glass powder containing the ceramic filler 9, and the fluidity during firing is lowered. Such a second protective layer 8 is provided on the upper surface of the first protective layer 7, whereby it is possible to reduce the formation of surface irregularities on the surface of the sintered product. Accordingly, it is possible to improve the flatness of the mounting portion 10 for the light-emitting element, reduce the heat resistance, and also suppress inclination when a light-emitting element is mounted.

Further, as shown in Fig. 3, the second protective layer 8 made of the sintered product of a glass powder containing the ceramic filler 9, is provided on the upper side of the reflection layer 6 in Fig. 3, whereby part of light L1 entering the second protective layer 8 from the light-emitting element 10 collides with the interface between the glass and the ceramic filler 9 before arriving at the reflection layer 6, and is reflected or diffracted due to the refractive index difference between the glass and the ceramic filler 9. Accordingly, it is possible to diffuse the reflection direction of light emitted from the light-emitting element, and it is thereby possible to reduce the fluctuation in light distribution characteristics of reflected light.

As a glass powder to be used for the second protective layer 8, it is possible to suitably use the above-mentioned glass powder for the first protective layer 7.

Further, it is preferred to use, as the glass powder for the second protective layer 8, the same one as the glass powder for the first protective layer 7, but it is also possible to use another glass powder so long as it is the above-mentioned glass powder for the first protective layer.

As the ceramic filler 9 to be used in the second protective layer 8, one which has been commonly used, can be used without particular restriction.

As such a ceramic filler, for example, an alumina filler, an alumina powder, a zirconia powder, a titania powder or a mixture thereof can be suitably used.

The 50% particle size (D₅₀) of the ceramic filler is preferably, for example, from 0.5 µm to 4 µm.

Such a ceramic filler 9 and a glass powder for a protective layer may be blended and mixed, for example, so that the content of the ceramic filler 9 to the second protective layer 8 would be from 10 mass% to 30 mass%, to obtain a glass ceramic composition.

If the content of the ceramic filler 9 is less than 10 mass%, the fluidity of the second protective layer 8 in a non-fired state becomes too high, therefore e.g. swell is likely to be formed during the firing, whereby surface irregularities are likely to be formed on the surface of a fired product, and the flatness of the mounting portion 10 is likely to deteriorate.

On the other hand, if the content of the ceramic filler 9 exceeds 30 mass%, it becomes difficult to carry out firing, the fluidity of the glass powder becomes inadequate during the firing, and it is thereby difficult to obtain a sintered product having the respective particles of the ceramic filler 9 uniformly covered by a glass powder sintered product, whereby the flatness of the second protective layer 8 is likely to deteriorate, the acid resistance or strength is likely to deteriorate, and it is less likely to function sufficiently as a protective layer for the reflection layer 6.

The content of the ceramic filler 9 is preferably at most 25 mass%.

The first protective layer 7 and the second protective layer 8 can be formed in such a method that a ceramic filler is blended with the above-mentioned glass powder to obtain a composition, to which e.g. a binder is added so as to be formed into a paste, and the paste is printed on the substrate main body 2 by screen printing, followed by firing.

The thickness of the first protective layer 7 is preferably from 10 µm to 30 µm.

If the thickness of the first protective layer 7 is less than 10 µm, the distance from the surface of the reflection layer 6 to the second protective layer 8 is too short, and at the time of firing, silver ions are likely to arrive at the second protective layer 8, whereby a silver powder is likely to be exposed on the surface 8A of the second protective layer 8. On the other hand, if the thickness of the first protective layer 7 exceeds 30 µm, the volume of the first protective layer 7 is too large and the heat conductivity thereby deteriorates, and further e.g. swell at the time of firing the first protective layer 7 is likely to affect the surface 8A of the second protective layer 8, whereby the flatness of the mounting portion 10 is likely to deteriorate. The thickness of the first protective layer 7 is more preferably from 20 µm to 25 µm.

The thickness of the second protective layer 8 is preferably from 10 µm to 30 µm.

If the thickness of the second protective layer 8a is less than 10 µm, e.g. irregularities of the surface of the surface layer (the surface being in contact with the second protective layer 8) of the first protective layer 7 is likely to affect the surface 8A of the second protective layer 8, whereby the flatness of the mounting portion 10 is likely to deteriorate.

On the other hand, if the thickness of the second protective layer 8 exceeds 30 µm, the heat conductivity is likely to deteriorate. The thickness of the second protective layer 8 is more preferably from 20 µm to 25 µm.

A material or the like of the substrate main body 2 is not particularly limited so long as it is a flat plate-form member, but preferred is one which undergoes no deformation even when pastes of the glass ceramic composition for the first protective layer 7 and for the second protective layer 8 are fired on the surface of the substrate 2, and an inorganic material is preferably used.

Among the inorganic materials, an alumina ceramic, a low temperature co-fired ceramic (hereinafter referred to as LTCC) or aluminum nitride is, for example, preferably used from the viewpoint of excellent heat conductivity, heat dissipating property, strength and production costs.

Among the above inorganic materials, especially when LTCC is used as the substrate main body 2, the substrate main body 2, the reflection layer 6, the first protective layer 7 and the second protective layer 8 may be fired all at once, and therefore it is possible to efficiently produce the substrate 1 for mounting a light-emitting element.

The substrate main body 2 made of LTCC can be produced as follows.

First, a green sheet is formed. The green sheet can be produced by adding a binder and, as the case requires, a plasticizer, a solvent, etc. to a glass ceramic composition containing a glass powder for a substrate main body and a ceramic filler to prepare a slurry, and forming it into a sheet-form by e.g. a doctor blade method, followed by drying.

The glass powder for a substrate main body is not necessarily limited, but one having a glass transition point (Tg) of from 550°C to 700°C is preferred. If the glass transition point (Tg) is less than 550°C, the after-mentioned binder burn out is likely to be difficult. On the other hand, if the glass transition point (Tg) exceeds 700°C, the shrinkage start temperature tends to be high so that the dimension accuracy of the substrate main body 2 is likely to deteriorate.

As such a glass powder for a substrate main body, preferred is, for example, one comprising from 57 to 65 mol% of SiO₂, from 13 to 18 mol% of B₂O₃, from 9 to 23 mol% of CaO, from 3 to 8 mol% of Al₂O₃, and from 0.5 to 6 mol% in total of at least one member selected from K₂O and Na₂O.

The glass powder for a substrate main body can be obtained by producing a glass having the above-described glass composition by a melting method and grinding it by a dry grinding method or a wet grinding method.

In the case of a wet grinding method; it is preferred to employ water as a solvent. The grinding can be carried out by using a grinding machine such as a roll mill, a ball mill or a jet mill.

Here, the glass powder for a substrate main body is not necessarily limited to one consisting solely of the above components, but may contain other components within a range satisfying various properties such as a glass transition point. In a case where other components are contained, the total content thereof is preferably at most 10 mol%.

The 50% particle size (D₅₀) of the glass powder for a substrate main body 2 is preferably from 0.5 µm to 2 µm. If the 50% particle size of the glass powder for a substrate main body 2 is less than 0.5 µm, the glass powder is likely to cohere, whereby the handling tends to be difficult, and it tends to be difficult to uniformly disperse it. On the other hand, if the 50% particle size of the glass powder exceeds 2 µm, the glass softening temperature is like to rise, or the sintering is likely to be inadequate. The particle size can be adjusted, for example, by classification which is carried out after the grinding, as the case requires.

As the ceramic filler, one which has been used for the production of a LTCC substrate may be used without any particular restriction, and an alumina powder, a zirconia powder or a mixture of an alumina powder and a zirconia powder is preferably employed. The 50% particle size (D₅₀) of the ceramic filler is preferably from 0.5 µm to 4 µm for example.

The above glass powder for a substrate main body and the ceramic filler are blended and mixed, for example, so that the glass powder for a substrate main body would be from 30 mass% to 50 mass%, and the ceramic filler would be from 50 mass% to 70 mass%, to obtain a glass ceramic composition. Further, to this glass ceramic composition, a binder and, as the case requires, a plasticizer, a solvent, etc. are added to obtain a slurry.

As the binder, for example, polyvinyl butyral or an acrylic resin may be suitably used. As the plasticizer, for example, dibutyl phthalate, dioctyl phthalate or butylbenzyl phthalate may be employed. Further, as the solvent, an aromatic or alcohol organic solvent such as toluene, xylene or butanol may be employed. Further, a dispersing agent or a leveling agent may also be used.

This slurry is formed into a sheet-form by e.g. a doctor blade method, and dried to produce a green sheet. The green sheet thus produced can be cut into a prescribed size by using a punch or a punching machine, and at the same time, via holes for interlayer connection can be formed at prescribed positions by punching.

On the surface of the green sheet, a paste of an electroconductive metal is printed by means of e.g. screen printing to form a non-fired conductor pattern. Further, such a paste of a conductor metal is filled in the above-mentioned via holes for interlayer connection, to form a non-fired interlayer connection portion. Thus, non-fired connection terminals 3A, non-fired external electrode terminals 4A, non-fired via conductors 5A and non-fired reflection layers 6A are formed. As such a metal paste, one having a vehicle such as ethyl cellulose and, as the case requires, a solvent, etc. added to a metal powder containing e.g. copper, silver or gold as the main component, may be employed.

A plurality of green sheets on which a non-fired conductor pattern is formed, are laminated and integrated by heating and pressing while positioning them, and then kept e.g. at a temperature of from 500°C to 600°C for from 1 to 10 hours to carry out binder burn out whereby the binder such as a resin contained in the green sheet is decomposed/removed. Thereafter, heating is kept at a temperature of from 850°C to 900°C for 20 to 60 minutes, to fire the glass ceramic composition constituting the green sheets. By the firing, the interior of the glass ceramic substrate and the metal paste formed on the surface are also fired simultaneously to prepare a substrate main body 2 having connection terminals 3, external electrode terminals 4, via conductors 5 and reflection layers 6.

If the binder burn out temperature is lower than 500°C or the binder burn out time is less than 1 hour, the binder, etc. may not sufficiently be removed. On the other hand, when the binder burn out temperature is about 600°C, and the binder burn out time is about 10 hours, the binder, etc. can be sufficiently removed, and if the binder burn out temperature or time exceeds such a level, the productivity, etc. may rather deteriorate.

If the firing temperature is less than 850°C or the firing time is less than 20 minutes, one having a dense structure may not be obtainable. On the other hand, if the firing temperature is about 900°C and the firing time is about 60 minutes, one having an adequately dense structure is obtainable, and if the firing temperature or time exceeds such a level, the productivity etc. may rather deteriorate.

It is particularly preferred to carry out firing at a temperature of from 860°C to 880°C. In a case where a metal paste containing a metal powder composed mainly of silver is used for forming the reflection layer 6, if the firing temperature exceeds 880°C, the metal paste may be excessively softened, and a prescribed shape may not be maintained.

In the foregoing, the embodiment of the substrate 1 for mounting a light-emitting element of the present invention was described with reference to one example, but within the concept of the present invention, and as the case requires, the construction may suitably be changed.

As shown in e.g. Fig. 4, the light-emitting device of the present invention is such that a light-emitting element 11 light-emitting diode element is mounted on a mounting portion 10 of a second protective layer 8a, provided on a mounting surface 2a of a substrate 1 for mounting a light-emitting element. The light-emitting element 11 is fixed on the second protective layer 8 by using an adhesive, and electrodes which are not shown are electrically connected with connection terminals 3 by bonding wires 12. Further, a mold material 13 is provided so as to cover the light-emitting element 11 and the bonding wires 12 to constitute a light-emitting device 20.

As a sealing agent to form the mold material 13, for example a silicone resin is preferably used from the viewpoint of excellent light fastness and heat resistance. To the silicone resin, a catalyst such as platinum or titanium is added, whereby it is possible to cure the resin.

If a silver powder is exposed on the surface layer 8A of the second protective layer 8 as a surface being in contact with the mold material 13, silver particles are likely to be ionized and cohered to form colloidal particles by the catalyst such as platinum contained in the mold material 13, and these colloidal particles are likely to be further cohered, whereby the mold material 13 is colored brown in some cases.

According to the light-emitting device 20 of the present invention, the amount of silver particles exposed on the surface 8A of the second protective layer 8 is extremely reduced, whereby it is possible to suppress formation of silver ions into colloidal particles when e.g. the above platinum catalyst is in contact with the surface 8A, and therefore it is possible to suppress a coloring phenomenon of the mold material 13 and a region in the vicinity thereof due to agglomeration of the colloidal particles.

By mixing or dispersing e.g. a phosphor in the above sealing agent, light obtained from the light-emitting device 20 may suitably be adjusted to a desired emission color.

The emission color can be adjusted in such a method that, for example, a phosphor is mixed or dispersed in the sealing agent, whereby the phosphor is excited by light radiated from the light-emitting element 11 to emit visible light, and by color mixing of this visible light and the light radiated from the light-emitting element 11, a desired emission color from the light-emitting device 20 can be obtained.

Further, by color mixing of the light radiated from the light-emitting element 11 and visible light emitted from the phosphor, or by color mixing of visible lights themselves, a desired emission color from the light-emitting device 20 can be obtained.

The type of the phosphor is not particularly limited and may suitably be selected depending upon the type of light radiated from the light-emitting element or the desired emission color.

In the light-emitting device 20 of the present invention, the second protective layer 8 containing the ceramic filler 9 is provided, whereby light radiated from the light-emitting element 11 to the side of the substrate main body 2 is reflected upward by e.g. the reflection layer 6 and the ceramic filler 9, and the reflected light will enter the phosphor in the mold material 13 to emit visible light, or this reflected light will collide with the phosphor so as to be further refracted or reflected. Accordingly, light emitted from the light-emitting element can be dispersed in multi-direction, whereby the light-emitting device 20 is excellent in the light distribution characteristics.

Further, incorporation of the phosphor is not limited to the above method of mixing/dispersing it in the sealing agent, and for example, it is possible to separately provide a layer of a phosphor on the mold material 13.

According to the light-emitting device 20 of the present invention, by employing the substrate 1 for mounting a light-emitting element in which the amount of silver particles exposed on the surface 8A of the second protective layer 8 is extremely reduced, a coloring phenomenon due to agglomeration of colloidal particles in the mold material 13 can be suppressed, and a loss of light supplied from the light-emitting element 11can be reduced, whereby high brightness can be obtained with the light-emitting device 20.

Further, according to the light-emitting device 20 of the present invention, by employing the substrate 1 for mounting a light-emitting element being excellent in flatness of the mounting portion 10 and having a small heat resistance, an excessive temperature increase of the light-emitting element 11 can be suppressed, whereby light emission with high brightness can be achieved. Further, according to the light-emitting device 20 of the present invention, it is possible to obtain light of the good quality having a fluctuation in light distribution characteristics reduced.

Such a light-emitting device 20 of the present invention can suitably be used as a backlight for e.g. mobile phones or large-sized liquid crystal displays, as illumination for automobiles or decorations, or as other light sources.

Now, the present invention will be described in further detail with reference to Examples.

Firstly, glass ceramic compositions for the first protective layer 7 and the second protective layer 8 (hereinafter referred to as a protective layer) were produced. That is, raw materials were blended and mixed so that SiO₂ became 81.6 mol%, B₂O₃ 16.6 mol% and K₂O 1.8 mol%, and this raw material mixture was put into a platinum crucible and melted at 1,600°C for 60 minutes. Then, this molten state glass was cast and cooled. This glass was ground by a ball mill made of alumina for 20 hours to produce a glass powder for a protective layer. Here, ethyl alcohol was used as the solvent for grinding.

The average particle size D₅₀ (µm) of the glass powder for a protective layer thus obtained was measured by means of a laser diffraction/scattering type particle size distribution measuring apparatus (tradename: SALD21 00, manufactured by Shimadzu Corporation). The average particle size D₅₀ of the glass powder was 2.5 µm.

Further, the softening point (Ts) of a glass powder for a protective layer was measured by raising the temperature up to 1,000°C under a condition of a temperature raising rate of 10°C/min by means of a differential thermal analysis equipment (tradename: TG-DTA2000, manufactured by Bruker AXS K.K.). The softening point (Ts) of the glass powder was 775°C.

Then, an acid resistance test of the glass powder for a protective layer was carried out.

The acid resistance test was carried out in such a method that 4 g of the glass powder was put in a mold and pressed, and fired to obtain a sintered protect having a diameter of 14 mm and a height of 15 mm. Then the sintered product was immersed in 700 cm³ of an oxalate buffer solution having a pH of 1.68 at a temperature of 85°C, and the mass reduction after expiration of 1 hour was measured. Here, the mass after the immersion was measured after drying at 100°C for 1 hour.

The mass reduction per unit surface area of the sintered product of a glass powder was 0 µg/cm².

Then, a composition 1 for the first protective layer consisting solely of the above-mentioned glass powder for a protective layer was prepared without blending an alumina powder with the glass powder for a protective layer.

Further, an alumina powder (tradename: AL-45H, manufactured by Showa Denko K.K.) having a 50% particle size (D₅₀) of 2 µm was blended and mixed with the above glass powder for a protective layer so that the alumina powder content would be 30 mass%, to produce a glass ceramic composition 1 for the second protective layer.

Here, in Table, the mixing ratio of the glass powder and the alumina filler is represented by mass%.

A part of the above composition 1 for the first protective layer and the glass ceramic composition 1 for the second protective layer were put into a mold and subjected to press molding, and the molded product was processed into a disk having a diameter of 5 mm and a length of 1 mm. While a load of 10 g was exerted, the temperature was increased at a temperature raising rate of 10°C/min by means of a thermomechanical measuring apparatus (tradename: TMA50, manufactured by Shimadzu Corporation), and the temperature at which a sample started to shrink (the shrinkage start temperature) Td (°C) was measured. The shrinkage start temperatures of the composition 1 for the first protective layer and the glass ceramic composition 1 for the second protective layer were respectively 730°C and 750°C.

### EXAMPLE 1

The above composition 1 for the first protective layer and a resin component were blended in such a proportion that the glass ceramic composition would be 60 mass% and the resin component would be 40 mass%, followed by kneading for 1 hour in a porcelain mortar, and further by dispersion three times by means of a three roll mill to prepare a glass paste 1 for the first protective layer.

Further, the glass ceramic composition 1 for the second protective layer and a resin component were blended in such a proportion that the glass ceramic composition would be 60 mass% and the resin component would be 40 mass%, followed by kneading for one hour in a porcelain mortar, and further by dispersion three times by means of a three roll mill to prepare a glass paste 1 for the second protective layer. Further, as the resin component, one having ethyl cellulose and α-terpineol blended and dispersed in a mass ratio of 85:15, was used.

Then, a green sheet 2 for a substrate main body was produced.

Firstly, raw materials were blended and mixed so that the SiO₂ content would be 60.4 mol%, B₂O₃ 15.6 mol%, Al₂O₃ 6 mol%, CaO 15 mol%, K₂O 1 mol% and Na₂O 2 mol%, and this raw material mixture was put into a platinum crucible and melted at 1,600°C for 60 minutes. Then this molten state glass was cast and cooled. This glass was ground by a ball mill made of alumina for 40 hours to produce a glass powder for a substrate main body. Here, ethyl alcohol was used as the solvent for grinding.

35 Mass% of such a glass powder for a substrate main body, 40 mass% of an alumina powder (tradename: AL-45H, manufactured by Showa Denko K.K.) and 25 mass% of a zirconia powder (tradename: HSY-3F-J, manufactured by DAIICHI KIGENSO KAGAKU KOGYO CO., LTD.) were blended and mixed to produce a glass ceramic composition for a substrate main body. To 50 g of this ceramics composition for a glass substrate main body, 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of polyvinyl butyral (tradename: PVK#3000K, manufactured by DENKI KAGAKU KOGYO KABUSHIKI KAISHA) as a binder and 0.5 g of a dispersing agent (tradename: BYK180, manufactured by BYK Japan KK) were blended and mixed to prepare a slurry.

This slurry was applied on a PET film by a doctor blade method and dried to produce a green sheet for a main body so that its thickness would be 0.15 mm after firing.

On the other hand, an electroconductive powder (a silver powder, tradename: S550, manufactured by Daiken Chemical Co., Ltd.) and ethyl cellulose as a vehicle were blended in a mass ratio of 85:15 and dispersed in α-terpineol as a solvent so that the solid content would be 85 mass%, followed by kneading in a porcelain mortar for 1 hour, and further by dispersion three times by a three roll mill to prepare a silver paste.

On the portions corresponding to non-fired via conductors 5 of the green sheet 2 for a main body, through holes having a diameter of 0.3 mm were formed by means of a punching machine, and filled with the silver paste by a screen printing method to form a non-fired via conductor paste layer 5, and a non-fired connection terminal conductor paste layer 3 and a non-fired external electrode terminal conductor paste layer 4 were formed. Such green sheets were laminated and integrated by hot pressing to obtain a green sheet 2 for a main body provided with conductor paste layers.

At the center portion of a mounting surface 2a of the green sheet 2 for a main body provided with conductor paste layers, a paste layer 6 for a silver reflection film was formed by a screen printing method. The glass paste 1 for the first protective layer was applied by a screen printing method to form a first protective layer 7. On the first protective layer 7, the glass paste 1 for the second protective layer was further applied by a screen printing method to form a second protective layer 8, whereby a non-fired substrate 1 for mounting a light-emitting element was produced.

Further, a paste for the silver reflection layer 6 was prepared in such a manner method that a silver powder (tradename: S400-2, manufactured by Daiken Chemical Co., Ltd.) and ethyl cellulose as a vehicle were blended in a mass ratio of 85:15 and dispersed in α-terpineol as a solvent so that the solid content would be 85 mass%, followed by kneading for 1 hour in a porcelain mortar, and further by dispersion three times by a three-roll mill to produce a metal paste.

The above-obtained non-fired substrate 1 for mounting a light-emitting element was kept at 550°C for 5 hours to carry out binder burn out, and further kept at 870°C for 30 minutes to carry out firing, whereby a substrate 1 for mounting a light-emitting element was produced. The thickness of the first protective layer 7 formed on the substrate 1 for mounting a light-emitting element was 25 µm, and the thickness of the second protective layer 8 was 25 µm.

### COMPARATIVE EXAMPLES 1 and 2

A substrate 1 for mounting a light-emitting element was produced in the same method as in Example 1 except that no first protective layer 7 was formed on the paste layer 6 for a silver reflection film, and the glass paste for the second protective layer was directly applied on the paste layer 6 for a silver reflection film to form the second protective layer 8 (Comparative Example 1).

Further, a substrate 1 for mounting a light-emitting element was produced in the same method as in Example 1 except that the glass paste 1 for the first protective layer was applied on the paste layer 6 for a silver reflection film to form only the first protective layer 7, and no second protective layer 8 was formed thereon (Comparative Example 2).

Then, the substrate 1 for mounting a light-emitting element in each of Example 1 and Comparative Examples 1 and 2 was fired and then left to stand for 24 hours, and then the concentration of a silver (Ag) component contained in the first protective layer 7 or the second protective layer 8 was measured by means of an electron probe micro analyzer.

Further, in each of Example 1 and Comparative Example 1, the concentration of a silver (Ag) component in the sintered product of a glass powder in the region in the vicinity of Al₂O₃ in the second protective layer 8 having an alumina powder blended, was measured. Further, in Comparative Example 2, the concentration of a silver (Ag) component in an optional region of the sintered product of a glass powder in the first protective layer 7 was measured. The measurement results are shown in Table 1.

Then, on the substrate 1 for mounting a light-emitting element in each of the above Example 1 and Comparative Examples 1 and 2, a light-emitting diode element 11 was mounted to prepare a light-emitting device 20. On a mounting portion 10 of the second protective layer 8a, one light-emitting diode element 11 (tradename: GQ2CR460Z, manufactured by Showa Denko K.K.) was fixed by a die bonding material (tradename: KER-3000-M2, manufactured by Shin-Etsu Chemical Co., Ltd.), and electrodes which are not shown were electrically connected to connection terminals 3 by bonding wires 12. Further, by employing a sealing agent (tradename: CSR-1016A, manufactured by Shin-Etsu Chemical Co., Ltd.), sealing was carried out to form a mold material 13 as shown in Fig. 4. As the sealing agent, one containing a phosphor (tradename: P46-Y3, manufactured by Mitsubishi Chemical Holdings Corporation) in an amount of 20 wt% based on the sealing agent, was employed.

In such a state, the light-emitting device 20 was left to stand for 250 hours in an environment at a temperature of 85°C under a humidity of 85% to observe coloring conditions of the mold material 13.

### [Thermal resistance]

The thermal resistance of the substrate 1 for a light-emitting element having a light-emitting diode element mounted thereon was measured by means of a thermal resistance-measuring device (tradename: TH-2167, manufactured by Mine Koon Denki K.K.). Here, the applied electric current was 35 mA, and the electric current was conducted until the voltage drop was saturated, whereby the saturation temperature Tj (°C) was calculated by a temperature coefficient led from the dropped voltage and the temperature-voltage drop characteristic of the light-emitting diode element. The evaluation results are shown in Table 1.

Further, in Table 1, the measurement value of the saturation temperature Tj in Example 1 was regarded to be 100, and in each of Comparative Examples 1 and 2, a relative value was calculated from the measurement value of each saturation temperature Tj based on the measurement value in Example 1 as a standard.

When the above light-emitting diode element is used, the thermal resistance is preferably at most 30°C, more preferably at most 25°C. If the thermal resistance is higher than 30°C, the dropped voltage drop is likely to be prominent, and the light extraction efficiency or the service life of the light-emitting diode element is likely to deteriorate.

### [Luminous flux]

To the light-emitting element 11 (light-emitting diode element) of the light-emitting device 20 in each of Example and Comparative Examples, 35 mA of electric current was applied by means of a DC voltage/current generator (tradename: R6243, manufactured by ADVANTEST CORPORATION) to measure the total luminous flux (lumen) of light obtainable from the light-emitting device 20.

The total luminous flux was measured by providing the light-emitting device 20 in an integrating sphere (diameter of 6 inches), by means of a total luminous flux-measuring device (tradename: SOLIDLAMBDA - CCD . LED. MONITOR . PLUS, manufactured by Spectra Co-op). The measurement results are shown in Table 1.

Here, in Table 1, the measurement value of the luminous flux in Example 1 was regarded to be 100, and in each of Comparative Examples 1 and 2, a relative value was calculated from the measurement value of the luminous flux based on the measurement value in Example 1 as a standard.

**TABLE 1**

| | Concentration of silver (Ag) component (%) | Coloring conditions | Thermal resistance | Total luminous flux |
|---|---|---|---|---|
| Ex. 1 | 0.1 | Not observed | 100 | 100 |
| Com. Ex. 1 | 1.2 | Brown | 100 | 78 |
| Com. Ex. 2 | 0.1 | Not observed | 120 | 100 |

As is clear from Table 1, in the light-emitting device 20 in which the substrate 1 for mounting a light-emitting element in Comparative Example 1 was used, coloring was observed in the mold 13, and a decrease in the luminous flux was confirmed. Further, in the light-emitting device 20 in which the substrate 1 for mounting a light-emitting element in Comparative Example 2 was used, no coloring was observed in the mold material 13, but an increase of the thermal resistance was confirmed.

Whereas, in the light-emitting device 20 in which the substrate 1 for mounting a light-emitting element in Example 1 was used, no coloring was observed in the mold material 13, a large amount of luminous flux can be obtained, and further increase of the thermal resistance can be also suppressed.

### MEANING OF SYMBOLS

1: Substrate for mounting light-emitting element, 2: Substrate main body, 3: Connection terminal, 4: External electrode terminal, 5: Via conductor, 6: Reflection layer, 6A: metal ion (silver ion), 7: First protective layer, 8: Second protective layer, 8A: Surface of second protective layer 8, 9: Ceramic filler, 10: Mounting portion, 11: Light-emitting element, 12: Bonding wire, 13: Mold material, 20: Light-emitting device, 90: Alumina filler

## Claims

1. A substrate (1) for mounting a light-emitting diode element, which comprises a substrate main body (2), a reflection layer (6) composed mainly of silver (Ag) or a silver alloy, formed on a part of the substrate main body (2), a first protective layer (7) composed mainly of a sintered product of a glass powder, formed so as to cover the entire surface of the reflection layer (6), **characterised in that** first protective layer (7) contains less than 0.1% alumina filler (90), and **in that** said substrate further comprises a second protective layer (8) a part of which constitutes a mounting portion (10) on which a light-emitting diode element (11) is to be mounted, formed on the first protective layer (7), wherein the second protective layer (8) is made of a sintered product of a glass powder containing a ceramic filler (9).

2. The substrate (1) for mounting a light-emitting diode element according to Claim 1, wherein the concentration of silver (Ag) contained in the first protective layer (7) is at most 0.3%.

3. The substrate (1) for mounting a light-emitting diode element according to Claim 1 or 2, wherein the content of the ceramic filler (9) contained in the second protective layer (8) is at least 10 mass% and at most 30 mass%.

4. The substrate (1) for mounting a light-emitting diode element according to any one of Claims 1 to 3, wherein the ceramic filler (9) contained in the second protective layer (8) is one or a mixture of at least two selected from an alumina powder, a zirconia powder, a titania powder and a silica powder.

5. The substrate (1) for mounting a light-emitting diode element according to any one of Claims 1 to 4, wherein the thickness of the first protective layer (7) is at least 10 µm and at most 30 µm.

6. The substrate (1) for mounting a light-emitting diode element according to any one of Claims 1 to 5, wherein the thickness of the second protective layer (8) is at least 10 µm and at most 30 µm.

7. The substrate (1) for mounting a light-emitting diode element according to any one of Claims 1 to 6, wherein the reflection layer (6) is composed of a layer containing a metal selected from silver and an alloy of silver with an element of a platinum group, such as a silver/palladium alloy or a silver/platinum alloy.

8. A light-emitting device (20) comprising the substrate (1) for mounting a light-emitting diode element as defined in any one of Claims 1 to 7, and a light-emitting diode element (11) mounted on the mounting portion (10) of the substrate (1) for mounting a light-emitting diode element.

9. The light-emitting device (20) according to Claim 8, wherein a part or all of the surface of the substrate main body (2) and of the second protective layer (8) are sealed with a silicone resin (13) containing a platinum catalyst.

## Patentansprüche

1. Substrat (1) für die Montage eines Leuchtdiodenelements, das einen Substrathauptkörper (2), eine Reflexionsschicht (6), vorwiegend zusammengesetzt aus Silber (Ag) oder einer Silberlegierung, gebildet auf einem Teil des Substrathauptkörpers (2), eine erste Schutzschicht (7), vorwiegend zusammengesetzt aus einem gesinterten Produkt eines Glaspulvers, gebildet, um die gesamte Oberfläche der Reflexionsschicht (6) zu bedecken, umfasst, **dadurch gekennzeichnet, dass** die erste Schutzschicht (7) weniger als 0,1% Aluminiumoxid-Füllstoff (90) enthält, und dadurch, dass das Substrat weiter eine zweite Schutzschicht (8), wovon ein Teil ein Montageteil (10), auf dem ein Leuchtdiodenelement (11) zu montieren ist, bildet, gebildet auf der ersten Schutzschicht (7), umfasst, wobei die zweite Schutzschicht (8) aus einem gesinterten Produkt eines Glaspulvers, enthaltend einen keramischen Füllstoff (9), hergestellt ist.

2. Substrat (1) für die Montage eines Leuchtdiodenelements nach Anspruch 1, wobei die Konzentration von Silber (Ag), enthalten in der ersten Schutzschicht (7), höchstens 0,3% beträgt.

3. Substrat (1) für die Montage eines Leuchtdiodenelements nach Anspruch 1 oder 2, wobei der Gehalt des keramischen Füllstoffs (9), enthalten in der zweiten Schutzschicht (8), mindestens 10 Massenprozent und höchstens 30 Massenprozent beträgt.

4. Substrat (1) für die Montage eines Leuchtdiodenelements nach einem der Ansprüche 1 bis 3, wobei der keramische Füllstoff (9), enthalten in der zweiten Schutzschicht (8), eines oder ein Gemisch von mindestens zweien, ausgewählt aus einem Aluminiumoxidpulver, einem Zirkoniumdioxidpulver, einem Titandioxidpulver und einem Siliciumdioxidpulver, ist.

5. Substrat (1) für die Montage eines Leuchtdiodenelements nach einem der Ansprüche 1 bis 4, wobei die Dicke der ersten Schutzschicht (7) mindestens 10 µm und höchstens 30 µm beträgt.

6. Substrat (1) für die Montage eines Leuchtdiodenelements nach einem der Ansprüche 1 bis 5, wobei die Dicke der zweiten Schutzschicht (8) mindestens 10 µm und höchstens 30 µm beträgt.

7. Substrat (1) für die Montage eines Leuchtdiodenelements nach einem der Ansprüche 1 bis 6, wobei die Reflexionsschicht (6) aus einer Schicht, enthaltend ein Metall, ausgewählt aus Silber und einer Legierung von Silber mit einem Element der Platingruppe, wie beispielsweise eine Silber/Palladiumlegierung oder eine Silber/Platinlegierung, zusammengesetzt ist.

8. Lichtemittierende Vorrichtung (20), umfassend das Substrat (1) für die Montage eines Leuchtdiodenelements nach einem der Ansprüche 1 bis 7 und ein Leuchtdiodenelement (11), montiert auf dem Montageteil (10) des Substrats (1) für die Montage eines Leuchtdiodenelements.

9. Lichtemittierende Vorrichtung (20) nach Anspruch 8, wobei ein Teil oder die Gesamtheit der Oberfläche des Substrathauptkörpers (2) und der zweiten Schutzschicht (8) mit einem Siliconharz (13), enthaltend einen Platinkatalysator, versiegelt sind.

## Revendications

1. Substrat (1) pour monter un élément de diode électroluminescente, qui comprend un corps principal de substrat (2), une couche de réflexion (6) composée principalement d'argent (Ag) ou d'un alliage d'argent, formée sur une partie du corps principal de substrat (2), une première couche protectrice (7) composée principalement d'un produit fritté d'une poudre de verre, formé de façon à couvrir la surface entière de la couche de réflexion (6), **caractérisé en ce que** la première couche protectrice (7) contient moins de 0,1 % d'une charge d'oxyde d'aluminium (90), et **en ce que** ledit substrat comprend en outre une seconde couche protectrice (8) dont une partie constitue une portion de montage (10) sur laquelle un élément de diode électroluminescente (11) doit être monté, formé sur la première couche protectrice (7), dans lequel la seconde couche protectrice (8) est faite d'un produit fritté d'une poudre de verre contenant une charge céramique (9).

2. Substrat (1) pour monter un élément de diode électroluminescente selon la revendication 1, dans lequel la concentration d'argent (Ag) contenu dans la première couche protectrice (7) est au plus de 0,3 %.

3. Substrat (1) pour monter un élément de diode électroluminescente selon la revendication 1 ou 2, dans lequel la teneur de la charge céramique (9) contenue dans la seconde couche protectrice (8) est d'au moins 10 % en masse et au plus 30 % en masse.

4. Substrat (1) pour monter un élément de diode électroluminescente selon l'une quelconque des revendications 1 à 3, dans lequel la charge céramique (9) contenue dans la seconde couche protectrice (8) est l'une d'un mélange d'au moins deux éléments sélectionnés parmi une poudre d'alumine, une poudre de zircone, une poudre de dioxyde de titane et une poudre de silice.

5. Substrat (1) pour monter un élément de diode électroluminescente selon l'une quelconque des revendications 1 à 4, dans lequel l'épaisseur de la première couche protectrice (7) est au moins de 10 µm et au plus de 30 µm.

6. Substrat (1) pour monter un élément de diode électroluminescente selon l'une quelconque des revendications 1 à 5, dans lequel l'épaisseur de la seconde couche protectrice (8) est au moins de 10 µm et au plus de 30 µm.

7. Substrat (1) pour monter un élément de diode électroluminescente selon l'une quelconque des revendications 1 à 6, dans lequel la couche de réflexion (6) est composée d'une couche contenant un métal choisi parmi l'argent et un alliage d'argent avec un élément d'un groupe du platine, tel qu'un alliage argent/palladium ou un alliage argent/platine.

8. Dispositif émettant de la lumière (20) comprenant le substrat (1) pour monter un élément de diode électroluminescente tel que défini dans l'une quelconque des revendications 1 à 7, et un élément de diode électroluminescente (11) monté sur la portion de montage (10) du substrat (1) afin de monter un élément de diode électroluminescente.

9. Dispositif émettant de la lumière (20) selon la revendication 8, dans lequel une partie ou la totalité de la surface du corps principal de substrat (2) et de la seconde couche protectrice (8) est scellée avec une résine de silicone (13) contenant un catalyseur de platine.
